# EUROPEAN PATENT APPLICATION

(11) **EP 1 887 618 A1**
(43) Date of publication of application: **13.02.2008**
(21) Application number: 06746863.7
(22) Date of filing: 25.05.2006
(51) Int. Cl.: H01L 21/28, H01L 21/338, H01L 29/778, H01L 29/812

(54) **GROUP III-V NITRIDE COMPOUND SEMICONDUCTOR DEVICE AND ELECTRODE-FORMING METHOD**

(30) Priority: 03.06.2005 JP 2005163858
(71) Applicant: The Furukawa Electric Co., Ltd., Chiyoda-ku Tokyo 100-8322 (JP)
(72) Inventor: IKEDA, Nariaki THE FURUKAWA ELECTRIC CO., LTD., Tokyo 1008322 (JP); YOSHIDA, Seikoh THE FURUKAWA ELECTRIC CO., LTD., Tokyo 1008322 (JP)
(74) Representative: Schwabe - Sandmair - Marx
(86) International application number: PCT/JP2006/310484
(87) International publication number: WO 2006/129553

(57) **Abstract**

The present invention generally relates to a III-V nitride semiconductor device, and more particularly, to a III-V nitride semiconductor device, such as a GaN-based semiconductor device, which includes a low contact-resistant electrodes formed on an n-type layer of a semiconductor and a method of forming the above electrodes. To provide the method of forming the low contact-resistant electrodes and the semiconductor device including the electrodes, at least Ti, Al and Si are used as materials for the electrodes formed on the surface of the n-type layer of the III-V nitride semiconductor. More particularly, electrodes having a reliable performance can be obtained by forming a Ti layer on the surface of the n-type layer of the III-V nitride semiconductor and subsequently depositing a layer including a disordered phase of Al and Si on the Ti layer.

## Description

### TECHNICAL FIELD

The present invention generally relates to a III-V nitride semiconductor device, and more particularly, to a III-V nitride semiconductor device, such as a GaN-based semiconductor device, which includes a low contact-resistant electrode formed on an n-type layer of the semiconductor and a method of forming the electrode.

### BACKGROUND ART

Semiconductors including a nitride-based III-V group compound, such as GaN, InGaN, AlGaN, and AlInGaN, are direct bandgap semiconductors having large energies with reliable performances in a high temperature. Particularly, electronic devices or optical devices including GaN, such as a light emitting element, a light receiving element, a field effect transistor (FET), or a high electron mobility transistor (HEMT), have been studied and developed recently.

In a technique for fabricating an FET including GaN, a GaN buffer layer is formed on a semi-insulating substrate, such as a sapphire substrate, by employing the metal organic vapor deposition (MOCVD) method or the gas source molecular beam epitaxy (GSMBE) method. Semiconductor layers including GaN-based compounds with a predetermined composition are sequentially grown on the GaN buffer layer. As a result, an n-type layer having a predetermined layer structure in which a top surface layer functions as an active layer is fabricated. On the active layer, a source electrode, a drain electrode, and a gate electrode are formed. The gate electrode is positioned between the source electrode and the drain electrode.

In a typical technique for forming the above electrodes, a material for the electrodes is directly deposited on a surface of the n-type layer with a predetermined thickness by, for example, a vapor deposition. Thereafter, the electrodes formed on the n-type layer are annealed entirely. A structure of such electrodes includes a Ti layer and an Al layer. The electrodes formed on the n-type layer are required to show a high adhesiveness and a low contact resistance to the n-type layer.

Patent document 1: Japanese Patent Laid-open No. 2004-55840
Patent document 2: Japanese Patent Laid-open No. H7-221103

### DISCLOSURE OF INVENTION

### PROBLEM TO BE SOLVED BY THE INVENTION

Most of the electrodes formed on the n-type layer of the III-V nitride semiconductor, more particularly a GaN-based semiconductor, have a layer structure including Ti and Al deposited as materials of the electrodes by using a vacuum evaporation method or the like, and are annealed to form an ohmic contact. The higher temperature the electrodes are annealed at, the more strongly the electrodes adhesives to the semiconductor layer, because Ti layer formed on the surface of the n-type layer of the III-V nitride semiconductor well reacts with the nitride-based III-V group compound. However, when Al, which has a melting point of near 660°C, is used as a material of the electrodes, the annealed electrodes show a poor surface morphology and a contact resistance not low enough.

It is an object of the present invention to provide a method of forming low contact-resistant electrodes that are annealed to obtain a high adhesiveness to a surface of an n-type semiconductor and to provide a III-V nitride semiconductor device including the electrodes. Furthermore, it is another object to provide a III-V nitride semiconductor device including the electrodes, with a low On-resistance and a large maximum current on operation.

### MEANS FOR SOLVING PROBLEM

As a result of keen examinations for seeking a solution for the above problems, the inventors of the present invention have found that if at least Ti, Al and Si are used as materials included in the electrodes formed on the surface of the III-V nitride semiconductor, the formed electrodes have a high adhesiveness and a low contact resistance to the surface of the semiconductor. More particularly, electrodes having a Ti layer formed on the surface of the III-V nitride semiconductor and a layer including a disordered phase of Al and Si deposited on the Ti layer as a main part show more excellent properties. The disordered phase of Si and Al can be formed by depositing a Si layer and an Al layer on the Ti layer that is formed on the surface of the III-V nitride semiconductor and annealing the two layers. If a Mo layer is additionally formed on the Al layer or the layer including the disordered phase of Al and Si, the electrodes can maintain excellent surface morphology even after the annealing process. Instead of Mo, elements such as Nb, Ta, W, Re, Os, Ni, Pt, Ir, and Ti can be used for the top surface layer. Another layer including Au or Pt can be further formed on a top thereof.

A thickness of the Ti layer formed on the surface of the n-type layer of the III-V nitride semiconductor is preferably 0.02 micrometer to 0.03 micrometer. A thickness of the layer including Si and Al is preferably 0.08 micrometer to 0.12 micrometer. A Si:Al composition ratio is preferably in a range from 0.05:0.95 to 0.35:0.65. The layer including Si and Al can be formed by sequentially depositing a Si layer and an Al layer and annealing the two layers to diffuse Si and Al. In this case, a preferable thickness of the Si layer is 0.01 micrometer to 0.03 micrometer, and a preferable thickness of the Al layer is 0.07 micrometer to 0.10 micrometer. After the layers of the electrodes are deposited on the surface of the n-type layer of the III-V nitride semiconductor, the electrodes are annealed preferably at 650°C to 1100°C, more preferably, at 800°C to 1000°C.

If an insulating protective film is formed over the electrodes, it is preferable to additionally form a Ti layer as the top surface layer of the electrodes, placed on a boundary surface between the insulating protective film and the electrodes. The Ti layer enhances the adhesiveness between the electrodes and the insulating protective film.

### EFFECT OF THE INVENTION

According to the present invention, it is possible to obtain an effect of forming the low contact-resistant electrodes having a high adhesiveness to the surface of the semiconductor by using at least Ti, Al, and Si as materials of the electrodes.

### BRIEF DESCRIPTION OF DRAWINGS

Fig. 1 is a cross-sectional view of a GaN-based semiconductor FET according to a first embodiment of the present invention;
Fig. 2 is a chart for comparing semiconductor devices having different structures of electrodes in contact resistance;
Fig. 3 is a cross-sectional view of a GaN-based semiconductor FET according to a second embodiment of the present invention; and
Fig. 4 is a cross-sectional view of a GaN-based semiconductor FET according to a third embodiment of the present invention.

### EXPLANATIONS OF LETTERS OR NUMERALS

- 1: Substrate
- 2: Buffer layer
- 3: Channel layer
- 4: Electron-supplying layer
- 5: Ti layer
- 6: Al-Si alloy layer
- 7: Mo layer
- 8: Si layer
- 9: Al layer
- 10: Ni layer
- 11: Au layer
- 12: Ti layer
- 13: Insulating protective film

### BEST MODE(S) FOR CARRYING OUT THE INVENTION

Exemplary embodiments of a III-V nitride semiconductor device according to the present invention will be described below with reference to the accompanying drawings. The present invention is not limited to these exemplary embodiments.

### First embodiment

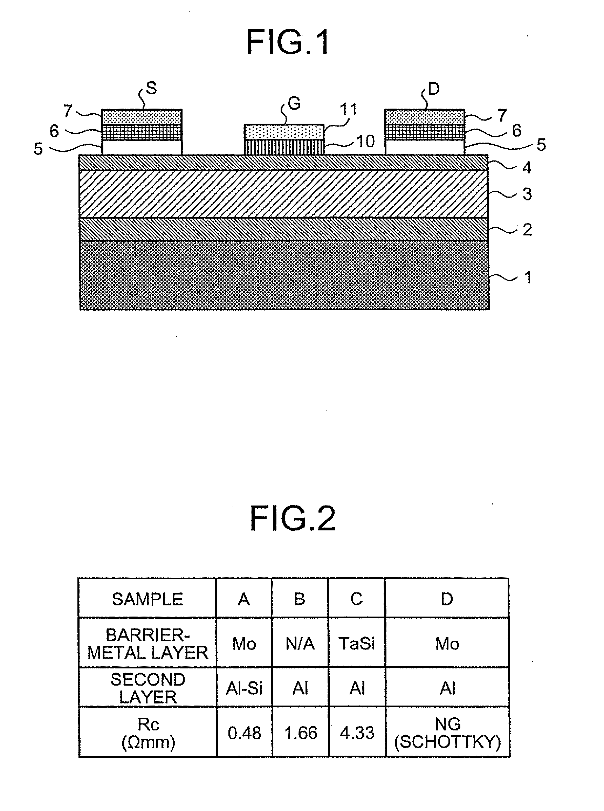

Fig. 1 is a cross-sectional view of a GaN-based semiconductor FET as an example of the III-V nitride semiconductor device according to a first embodiment of the present invention. The GaN-based semiconductor FET includes a silicon (111) substrate 1 on which a buffer layer including, for example, GaN, an undoped GaN layer functioning as a channel layer 3 of the FET, and an undoped AlGaN layer functioning as an electron-supplying layer 4 are sequentially formed. On the undoped AlGaN layer, a source electrode S, a gate electrode G, and a drain electrode D are formed.

Because the undoped GaN layer (the channel layer 3), which defines a length of a channel, and the undoped AlGaN layer (the electron-supplying layer 4) creates a heterojunction, a two-dimensional electron gas is generated on an interface of a junction area. Because the two-dimensional electron gas functions as a carrier, the channel layer 3 shows a conductive property. Each of the source electrode S and the drain electrode D includes a Ti layer 5, an Al-Si alloy layer 6 including a disordered phase of Al and Si, and a Mo layer 7, those sequentially deposited from the side closer to the surface of the electron-supplying layer 4. The gate electrode G includes a Ni layer 10 and a Au layer 11, sequentially deposited.

Fig. 2 is a chart for comparing semiconductor devices having different structures of the source electrode S and the drain electrode D in contact resistance Rc. A sample "A" indicates a semiconductor device including the source electrode S and the drain electrode D according to the first embodiment. Samples "B" to "D" indicate semiconductor devices including conventional source electrodes and drain electrodes. Each of the electrodes in the samples includes a Ti layer as a first layer formed on the electron-supplying layer 4 and a layer including a disordered phase of Al and Si or an Al layer as a second layer formed on the first layer. A barrier-metal layer is a layer formed on the second layer.

As shown in Fig. 2, The sample "A" including the disordered phase of Si and Al as the second layer, has a much lower contact resistance Rc than those of the samples "B" to "D" including the Al layer as the second layer according to the conventional techniques. It means that a GaN-based semiconductor FET with a much lower On-resistance at the operation can be realized using the sample "A".

A method of fabricating the above GaN-based semiconductor FET is described bellow.

### (1) Semiconductor fabricating process

The substrate 1 made of Si (111) is arranged in an MOCVC device. After a chamber of the MOCVD is pumped to be at 1x10⁻⁶ hPa or lower by a turbo pump, the substrate 1 is heated at 1100°C at 100 hPa. When the temperature becomes stable, the substrate 1 starts spinning at 900 rpm, and trimethylaluminum (TMA) with a feed rate of 100 cm³/min and ammonia with a feed rate of 12 L/min, which are used as materials, are injected to a surface of the substrate 1 to grow a GaN buffer layer 2. A growth time of the GaN buffer layer 2 is 4 minutes, and a thickness of the GaN buffer layer 2 is about 50 nanometers.

Subsequently, trimethylgallium (TMG) with a feed rate of 100 cm³/min and ammonia with a feed rate of 12 L/min are injected to a surface of the buffer layer 2 to grow the channel layer 3 formed with a GaN layer. A growth time of the channel layer 3 is 1000 seconds, and a thickness of the channel layer 3 is about 800 nanometers. Further subsequently, trimethylaluminum (TMA) with a feed rate of 50 cm³/min, trimethylgallium (TMG) a feed rate of 100 cm³/min, and ammonia a feed rate of 12 L/min are injected to grow the electron-supplying layer 4 including Al_{0.25}Ga_{0.75}N. A growth time of the electron-supplying layer 4 is 40 seconds, and a thickness of the electron-supplying layer 4 is 20 nanometers. As a result of the above process, the structure of the semiconductor device shown in Fig. 1 (except the electrodes) is formed.

### (2) Electrode forming process

A SiO₂ film is formed on the electron-supplying layer 4 by using, for example, the plasma chemical vapor deposition (CVD) method. A thickness of the SiO₂ film is about 300 nanometers. After patterning the SiO₂ film so that an area where the gate electrode G is to be formed is masked and areas where the source electrode S and the drain electrode G are to be formed are opened, the source electrode S and the drain electrode D are formed by sequentially depositing Ti, an Al-Si alloy film, and Mo on the opened area of the surface of the electron-supplying layer 4. After the above layers are deposited, the electrodes are annealed at 900°C for one minute. A thickness of the Ti layer 5 is 0.25 micrometer. A thickness of the Al-Si alloy layer 6 is 0.10 micrometer, and an Al:Si composition ratio is 0.88:0.12. Next, after the areas where the source electrode S and the drain electrode G are formed are masked with the SiO₂ film and the area where the gate electrode G is to be formed is opened, the gate electrode G is formed by sequentially depositing Ni and Au. As a result, the FET shown in Fig. 1 is fabricated. The contact resistance of the source electrode S and the drain electrode D of the FET fabricated in the above process is 0.5 Ωmm.

According to an Auger analysis of a cross-sectional surface of the annealed electrodes, Al is diffused to the Ti layer, which forms a TiAl layer of a thickness of 0.025 micrometer, which has a Ti:Al composition ratio of 25:60. Similarly, Mo is diffused to the AlSi layer on the TiAl layer, which forms a 0.1-micrometer-thick disordered phase, which has an Al:Si:Mo composition ratio of about 57:7:10. It is found from the analysis that, although some elements included in the electrodes are diffused, the surface morphology of the annealed electrodes are not degraded comparing with those of the electrodes before the annealing process and no trouble is caused about wire bonding.

### Second embodiment

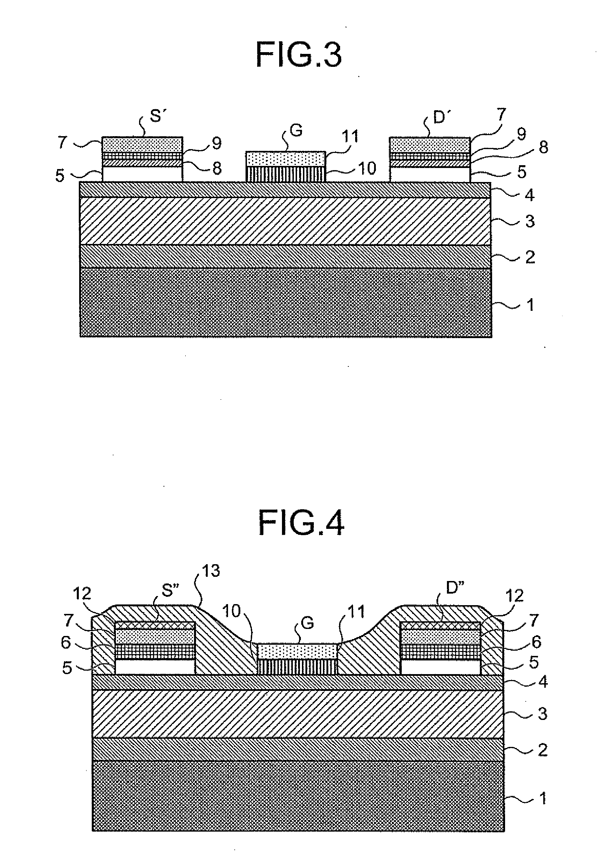

Fig. 3 is a cross-sectional view of a GaN-based semiconductor FET as an example of a III-V nitride semiconductor device according to a second embodiment of the present invention. The semiconductor part is fabricated in a manner similar to that in the first embodiment. In the process of forming the electrodes, Ti layer 5 of a thickness of 0.025 micrometer, a Si layer 8 of a thickness of 0.010 micrometer, and an Al layer 9 of a thickness of 0.090 micrometer are sequentially deposited on areas where a source electrode S' and a drain electrode D' is to be formed. Subsequently, the Mo layer 7 is formed on the Al layer 9. The gate electrode G is formed by sequentially depositing the Ni layer 10 and the Au layer 11 on the area for the gate electrode. Subsequently, the electrodes are annealed at 900°C for one minute. In the annealed source electrode S' and the annealed drain electrode D', a disordered phase of Si and Al is formed, and a contact resistance is 0.5 Ωmm.

As a result of the formation of the disordered phase of Si and Al in the above process, parts of Si and Al can be remained not included in the disordered phase, forming layers positioned upper and lower parts of the disordered phase. In this case, the formed source electrode S' and the formed drain electrode D' include the Ti layer 5 on which the Si layer, the layer including the disordered phase of Si and Al, and the Al layer are sequentially deposited.

### Third embodiment

Fig. 4 is a cross-sectional view of a GaN-based semiconductor FET as an example of a III-V nitride semiconductor device according to a third embodiment of the present invention. As shown in Fig. 4, the GaN-based semiconductor FET according to the third embodiment includes, based on a structure of the GaN-based semiconductor FET according to the first embodiment, a source electrode S" and the drain electrode D" obtained by forming a Ti layer 12 on a top surface layer of each of the source electrode S and the drain electrode D. In addition, an insulating protective film 13 including SiOₓ or SiNx is formed over the source electrode S" and the drain electrode D".

By forming the Ti layer 12 functioning as an adhesive layer as the top surface layer of each of the source electrode S and the drain electrode D, which is placed a boundary surface between the electrodes and the insulating protective film 13, an adhesiveness of the insulating protective film 13 to the electrodes is more improved than that in the case the insulating protective film 13 is directly formed on the Mo layer 7. The Mo layer 7 can be replaced with a layer including Nb, Ta W, Re, Os, Ni, Pt or IR. Similarly, if the Ti layer is formed on the above replacing layer, the adhesiveness of the insulating protective film 13 to the electrodes is improved. It is also allowable to replace the Mo layer 7 with the Ti layer and form the insulating protective film 13 on the replacing Ti layer.

The GaN-based semiconductor FET according to the third embodiment is fabricated in the similar process for fabricating the GaN-based semiconductor FET according to the first embodiment. Unlike the electrode forming process in the first embodiment, the source electrode S" and the drain electrode D" are formed by performing the annealing process after the Mo layer 7 and the Ti adhesive layer are deposited. After the gate electrode G is formed, the insulating protective film 13 is deposited. Although the annealing process can be performed before the Ti adhesive layer is deposited and after the Mo layer 7 is deposited, the annealing process is preferably performed after the Ti layer is deposited in the light of simplifying the fabricating process.

### INDUSTRIAL APPLICABILITY

As described above, the III-V nitride semiconductor device and the method of forming the electrodes according to the present invention are effective for the III-V nitride semiconductor device including the low contact-resistant electrodes formed on the n-type layer of the III-V nitride semiconductor and the method of forming the electrodes, and more particularly, suitable for the GaN-based semiconductor device including the low contact-resistant electrodes and the method of forming the electrodes.

## Claims

1. A III-V nitride semiconductor device, wherein at least Ti, Al, and Si are included as materials for electrodes formed on a surface of an n-type layer of a III-V nitride semiconductor.

2. The III-V nitride semiconductor device according to claim 1, wherein
the electrode includes at least a first layer and a second layer, sequentially deposited on the surface of the n-type layer of the III-V nitride semiconductor, and
the first layer includes at least Ti, and the second layer includes at least Al and Si.

3. The III-V nitride semiconductor device according to claim 2, wherein the second layer includes a disordered phase of Al and Si as a main part.

4. The III-V nitride semiconductor device according to claim 2 or 3, wherein the second layer has a structure in which a Si layer and an Al layer are sequentially deposited on a Ti layer.

5. The III-V nitride semiconductor device according to any one of claims 1 to 4, wherein the electrode further includes a layer including one or more elements selected from the group constituting of Mo, Nb, Ta, W, Re, Os, Ni, Pt, Ir, and Ti, deposited on the layers including Ti, Al, and Si.

6. The III-V nitride semiconductor device according to any one of claims 1 to 5, further comprising an insulating protective film formed on the electrode, wherein the electrode further includes a Ti layer as a boundary surface contacting to the insulating protective film.

7. A method of forming an electrode on a III-V nitride semiconductor, wherein
the electrode includes layers including at least Ti, Al, and Si, and
a first layer including at least Ti and a second layer including Al and Si are deposited on a surface of an n-type layer of the III-V nitride semiconductor.

8. A method of forming an electrode on a III-V nitride semiconductor, wherein
the electrode includes layers including at least Ti, Al, and Si, and
after at least a layer including Ti, another layer including Si, and still another layer including Al are sequentially deposited on a surface of an n-type layer of the III-V nitride semiconductor, deposited layers are annealed.

9. The method according to claim 7 or 8, wherein a layer including one or more elements selected from the group constituting of Mo, Nb, Ta, W, Re, Os, Ni, Pt, Ir, and Ti is additionally deposited on the layers including Ti, Al, and Si.

10. The method according to any one of claims 7 to 9, wherein a Ti layer is formed as a top surface layer.
